# EUROPEAN PATENT APPLICATION

(11) **EP 2 216 810 A2**
(43) Date of publication of application: **11.08.2010**
(21) Application number: 10001262.4
(22) Date of filing: 08.02.2010
(51) Int. Cl.: H01L 21/687

(54) **A support assembly for substrate holder, as well as a device provided with such a support assembly for layered deposition of various semiconductor materials on a semiconductor substrate**

(30) Priority: 10.02.2009 US 151456 P
(71) Applicant: Xycarb Ceramics B.V., 5705 CS Helmond (NL)
(72) Inventor: Campanieria IV, Juan Manuel, 78681 Rond Rock, Texas (US); Nitsche, Todd Steven, 75751 Athens, Texas (US); Wolthuis, Steven Scott, 78664 Round Rock, Texas (US)
(74) Representative: Valkonet, Rutger

(57) **Abstract**

The invention relates to a support assembly for a substrate holder on which a semiconductor substrate is to be placed for layered deposition of various semiconductor materials on the semiconductor substrate, said support assembly comprising: at least one vertically disposed, rotatably drivable support shaft, as well as a substrate holder support supporting the substrate holder, which is to be placed on the free end of said support shaft, as well as fixation means are arranged for fixing the support shaft and the substrate holder support in position relative to each other.

The invention also relates to a device for layered deposition of various semiconductor materials on a semiconductor substrate, at least comprising a processing space accommodating at least one substrate holder, on which the semiconductor substrate is to be placed, means for supplying the various semiconductor materials in gaseous form into the processing space, which substrate holder can be supported in use by at least one support assembly according to the invention.

## Description

The invention relates to a support assembly for a substrate holder on which a semiconductor substrate is to be placed for layered deposition of various semiconductor materials on the semiconductor substrate, said support assembly comprising: at least one vertically disposed, rotatably drivable support shaft, as well as a substrate holder support supporting the substrate holder, which is to be placed on the free end of said support shaft, as well as fixation means are arranged for fixing the support shaft and the substrate holder support in position relative to each other.

The invention also relates to a device for layered deposition of various semiconductor materials on a semiconductor substrate, at least comprising a processing space accommodating at least one substrate holder, on which the semiconductor substrate is to be placed, means for supplying the various semiconductor materials in gaseous form into the processing space, which substrate holder can be supported in use by at least one support assembly according to the invention.

In semiconductor deposition processes, a semiconductor substrate is placed on a substrate holder, after which layered deposition of all kinds of semiconductor materials on a semiconductor substrate takes place. To realise an adequate control of said deposition process, the semiconductor substrate and the supporting substrate holder need to be rotated. The substrate holder is to that end placed on a support assembly whose support shaft is rotatably driven.

Since the substrate holder support is usually specifically constructed for a particular type of substrate holder, it must be simply removed from the support shaft, for example for adjusting the device.

A drawback of this construction is that slip occurs between the support shaft and the substrate holder support while the support shaft is rotatably driven, and in particular when the rotational movement is stopped, resulting in wear on both parts. Said wear in turn results in all kinds of contaminants being released, which contaminants adversely affect or disturb the deposition process.

A support assembly as referred to in the introduction is disclosed in U.S. patent publication No. US 2007/0056150 A1. Said publication discloses a support assembly in which the rotatably driven support shaft is provided with a keyway in which a locking key can be received for form-locked fixation of the substrate holder support placed on the support shaft.

A drawback of the support assembly disclosed in said U.S. patent publication is the complex assembly thereof, which requires the use of an additional part, i.e. the key, for fixing the support shaft and the substrate holder support in position relative to each other.

The object of the present invention is to provide a simplified construction comprising a reduced number of parts, by which on the one hand a more reliable fixation of the two parts relative to each other is realised, whilst on the other hand wear and the associated release of contaminants is prevented.

According to the invention, the support assembly is **characterised in that** the fixation means comprise at least one cam-slot assembly provided on the support shaft and the substrate holder support. The use of a cam-slot assembly obviates the need to use an additional, separate part. In addition, said cam-slot assembly allows for a simpler assembly and an improved mutual fixation during rotation of the support assembly in use.

A specific embodiment is **characterised in that** the substrate holder support comprises a hollow base, which can be placed over the free end of the support shaft, whilst in another functional embodiment the support shaft comprises a hollow free end, in which a base of the substrate holder support can be placed.

More specifically, the invention is to that end **characterised in that** the cam-slot assembly comprises at least one projecting cam formed on the support shaft or the substrate holder support and a corresponding slot formed in the substrate holder support or in the support shaft.

Not only is an adequate fixation of the support shaft and the substrate holder support realised in this way, but in addition there is no need for additional, separate parts, which allows for a simpler assembly and disassembly, since fewer adjusting operations are needed.

In specific embodiments, the cam-slot assembly may comprise at least one projecting cam formed on the support shaft and a slot formed in the substrate holder support, whilst in another embodiment the cam-slot assembly may comprise at least one slot formed in the support shaft and a projecting cam formed on the substrate holder support.

In another functional embodiment, the support assembly is **characterised in that** the slot is not supported on the projecting cam. This embodiment has the advantage that the projecting cam only extends partially into the slot (seen in the longitudinal direction of the slot) during placement of the substrate holder support on the support shaft, and consequently is not supported on the end edge of the slot and not on the substrate holder support, therefore. In this way contact between the two parts is avoided as much as possible, which prevents wear and also the release of contaminating particles.

The invention will now be explained in more detail with reference to a drawing, in which:
Figure 1 shows a first embodiment of a support assembly according to the invention;
Figure 2 shows another embodiment of a support assembly according to the invention.

For a better understanding of the invention, parts shown in the figures that correspond to each other are indicated by the same numerals in the description of the figures below.

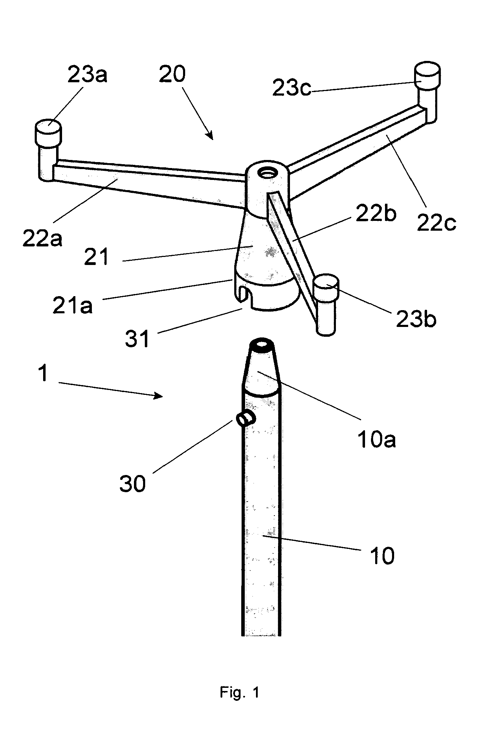

Reference numeral 1 indicates an embodiment of a support assembly according to the invention. A support assembly as shown in figure 1 is used in a device for layered deposition of the various semiconductor materials on a semiconductor substrate. To that end a semiconductor substrate is usually placed on a substrate holder, which is in turn supported by a support assembly as known per se.

The support assembly 1 that is shown in figure 1 is made up of only two parts, i.e. are vertically oriented support shaft 10 and a substrate holder support 20, which is to be placed on the support shaft 10. The substrate holder support 20 is made up of a central part 21 and several, three in this case, support arms 22a-22b-22c extending in a substantially horizontal plane. Each support arm 22a-22c is provided with a support point 23a-23c near its free end, on which the substrate holder to be supported is to be placed.

Usually, all kinds of semiconductor materials are deposited in extremely thin layers on a semiconductor substrate by means of semiconductor deposition processes in such a device.

In order to realise a precise control of the deposition processes and adapt said processes, if necessary, a support assembly according to the prior art is rotatably driven. Usually, the support shaft 10 is to that end connected to suitable drive means in a known manner (not shown), which drive means impose a direction of rotation on the support shaft 10.

The substrate holder (not shown) is supported on the support points 23a-23c. The support assembly, the substrate holder and the semiconductor substrate are rotated by the elongated, vertically oriented support shaft, which is rotated in a manner which is known per se.

Because of the rotational movement of the support assembly 1, the substrate holder (not shown) and the semiconductor placed on the substrate holder the deposition of the various semiconductor materials can be measured and controlled more easily.

A drawback of the currently known support assemblies is the fact that slip may occur between the two parts, i.e. the support shaft and the substrate holder support 20, after the rotational movement. Relative slip between the two parts in the first place leads to wear. In addition, contaminants may come off the support shaft 10 and/or the substrate holder support 20, which in their turn will adversely affect the deposition process.

To prevent any slip that may occur during rotation of the support shaft and the substrate holder support, the support assembly is provided with specific fixation means, which comprise at least one cam-slot assembly 30-31 provided on the support shaft 10 / the substrate holder support 20.

In the embodiment shown in figure 1, the support shaft 10 is provided with a projecting cam 30, which can be received in the slot 31 formed in the circumferential edge 21 a of the hollow end 21 of the substrate holder support 20. Said substrate holder end 21 is hollow and slips over the support shaft 10 upon placement of the substrate holder support 20 on the support shaft. By adequately aligning the substrate holder support 20 relative to the support shaft 10, the slot 31 formed in the circumferential edge 21 a will slip over the cam 30. Thus, a rotational fixation between the two parts is effected.

The latter ensures that no slip will occur between the support shaft 10 and the substrate holder support 20 during the rotational movement of the support shaft 10, in particular while said rotational movement is being started and stopped. This prevents wear or other damage on/to the material of the two parts as a result of said slip. Because of this optimum rotational fixation realised by means of the cam-slot assembly 30-31, unwanted release of all kinds of contaminants is prevented, so that the semiconductor deposition process will not be affected.

Although only one cam-slot assembly 30-31 is shown in figure 1, it will of course be apparent that more, for example two full or three, cam-slot assemblies may be provided. The support shaft 10 may to that end be provided with several cans 30 arranged around the circumference of the support shaft, which cams mate with corresponding slots formed in the free circumferential edge 21 a of the substrate support holder shaft 21.

In another embodiment, the cam 30 of the cam-slot assembly is provided on the inner side of the hollow substrate holder support shaft 21. This inwardly oriented cam can be received in a corresponding slot extending in the longitudinal direction from the free end 10a of the support shaft 10. Also in this case a number of cam-slot assemblies may be provided with a view to realising an optimum rotational fixation of the substrate holder support 20 relative to the rotary support shaft 10.

To prevent damage to the two parts and prevent unwanted release of particles, which might otherwise affect the deposition process, the slot 31 is not supported on the cam 30; since the projecting cam 30 is not supported on the end edge of the slot 31, continuous contact between the two parts is prevented and the deposition process will not be affected (by particles being released).

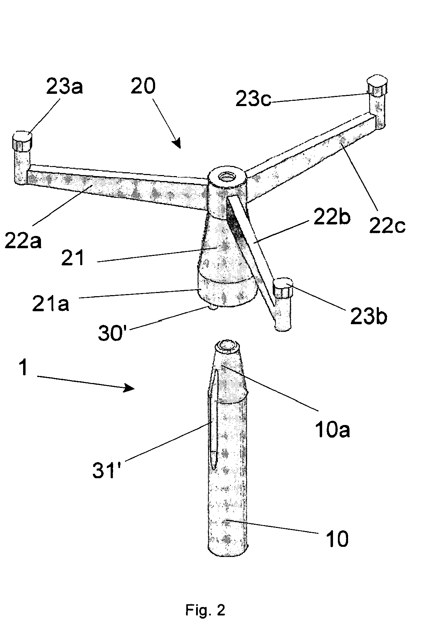

Figure 2 shows another embodiment of a support assembly according to the invention. In this embodiment, the support shaft 10 is provided with a longitudinally extending slot 31', which can receive a projecting cam 30' formed on the circumferential edge 21 a of the substrate holder support end 21 of the substrate holder support 20.

In this embodiment, too, the substrate holder support is hollow, so that it will slip over the support shaft 10 upon placement of the substrate holder support 20 or on the support shaft. By correctly aligning the substrate holder support 20 with the support shaft 10, analogously to the embodiment shown in figure 1, the cam 30' projecting from the circumferential edge 21 a will slip into the slot 31' formed in the support shaft 10.

In this case, too, a rotational fixation between the two parts 10-20 is effected, so that no slip will occur between the support shaft 10 and the substrate holder support 20 during the rotational movement of the support shaft 10, and in particular when said rotational movement is being started and stopped. Thus, wear or damage on/to the material of the two parts is prevented, and unwanted release of all kinds of contaminants is avoided, so that the semiconductor deposition process will not be affected.

It is furthermore noted that in both embodiments more than one cam-slot assembly 30-31 (and 30'-31') may be used for realising a better rotational fixation. Wider slots may be used in that case, in which a (likewise wider) cam can be received.

## Claims

1. A support assembly for a substrate holder on which a semiconductor substrate is to be placed for layered deposition of various semiconductor materials on the semiconductor substrate, said support assembly comprising:
at least one vertically disposed, rotatably drivable support shaft, as well as
a substrate holder support supporting the substrate holder, which is to be placed on the free end of said support shaft, as well as
fixation means are arranged for fixing the support shaft and the substrate holder support in position relative to each other, **characterised in that** the fixation means comprise at least one cam-slot assembly provided on the support shaft and the substrate holder support.

2. A support assembly according to claim 1, **characterised in that** the substrate holder support comprises a hollow base, which can be placed over the free end of the support shaft.

3. A support assembly according to claim 1, **characterised in that** the support shaft comprises a hollow free end, in which a base of the substrate holder support can be placed.

4. A support assembly according to one or more of claims 1-3, **characterised in that** the cam-slot assembly comprises at least one projecting cam formed on the support shaft or the substrate holder support and a corresponding slot formed in the substrate holder support or in the support shaft.

5. A support assembly according to claim 4, **characterised in that** the cam-slot assembly comprises at least one projecting cam formed on the support shaft and a slot formed in the substrate holder support.

6. A support assembly according to claim 4, **characterised in that** the cam-slot assembly comprises at least one slot formed in the support shaft and a projecting cam formed on the substrate holder support.

7. A support assembly according to one or more of the preceding claims, **characterised in that** the slot is not supported on the projecting cam.

8. A device for layered deposition of various semiconductor materials on a semiconductor substrate, at least comprising a processing space accommodating at least one substrate holder, on which the semiconductor substrate is to be placed, means for supplying the various semiconductor materials in gaseous form into the processing space, which substrate holder can be supported in use by at least one support assembly according to one or more of the preceding claims.
